# FASCICULE DE BREVET EUROPEEN

(11) **EP 0 435 717 B1**
(45) Date de publication et mention de la délivrance du brevet: **31.08.1994**
(21) Numéro de dépôt: 90403493.1
(22) Date de dépôt: 07.12.1990
(51) Int. Cl.: H05K 3/42

(54) **Procédé d'interconnexion de couches métalliques du réseau multicouche d'une carte électronique et carte en résultant**
Verfahren zur Vermaschung von Metallschichten einer Mehrschichtschaltung einer elektronischen Leiterkarte und auf diese Weise produzierte Leiterkarte
Process for interconnecting of metallic layers in multilayer circuits of an electronic board and the board produced by the process

(30) Priorité: 21.12.1989 FR 8916956
(43) Date de publication de la demande: 03.07.1991
(73) Titulaire: BULL S.A., 92800 Puteaux (FR)
(72) Inventeur: Chantraine, Philippe, F-75764 Paris Cédex 16 (FR); Zorrilla, Marta, F-75764 Paris Cédex 16 (FR)
(74) Mandataire: Denis, Hervé

(56) Documents cités:
- DE-A- 3 125 730
- DE-U- 8 711 105
- FR-A- 2 117 172
- US-A- 3 319 317
- US-A- 3 672 986

## Description

L'invention a pour objet un procédé d'interconnexion de couches métalliques du réseau multicouche d'une carte électronique. Une carte électronique sert à la connexion d'au moins un circuit intégré de haute densité encore appelé circuit VLSI (Very Large Scale Integrated circuit). Elle peut servir à l'interconnexion de plusieurs circuits intégrés montés en surface, ou simplement au support d'un seul circuit intégré placé dans un boîtier, par exemple en substitution du support classique actuel couramment appelé "chip carrier".

Dans une telle carte, le réseau multicouche est ordinairement porté par un substrat fait d'une plaque isolante incorporant les plans de distribution des potentiels d'alimentation du ou des circuits intégrés. Le substrat peut être une plaque de céramique cocuite, ou une plaque faite d'un matériau organique, en plastique par exemple. La carte pourrait aussi être simplement formée du réseau multicouche, prenant alors la forme d'une carte souple. La carte peut encore être une plaque de matériau semiconducteur incorporant les circuits intégrés et recouverte d'un réseau multicouche pour l'interconnexion de ces circuits intégrés selon la technologie dite WSI (Wafer Scale Integration). Dans toutes ces cartes, le réseau multicouche se compose d'un empilement de couches conductrices et isolantes alternées. Dans cet empilement, une couche isolante est percée de traversées (via-holes en terminologie anglo-saxonne) pour la liaison électrique des couches conductrices entre elles. Les couches conductrices sont ordinairement faites d'aluminium ou de cuivre, et les couches isolantes sont aujourd'hui faites de préférence en un matériau polymérisé tel qu'un polyimide.

Un problème dans la fabrication du réseau métallique multicouche est l'optimisation de la densité du réseau métallique multicouche. Actuellement, les traversées sont évasées pour faciliter le dépôt de la couche métallique supérieure. Cependant, l'évasement exige un positionnement précis sur chaque traversée et un contrôle du degré d'évasement. De plus, l'évasement oblige à élargir les conducteurs, au détriment de la haute densité recherchée des conducteurs dans le réseau. Pour résoudre ce problème, les traversées sont simplement des trous cylindriques ou prismatiques. Cependant, la présence de ces simples trous pose un second problème, résidant dans l'obtention de couches relativement planes afin de superposer un grand nombre de couches métalliques dans le réseau. Ce problème est d'autant plus grave que les couches isolantes sont épaisses. Dans les cartes actuelles, des couches isolantes peuvent avoir une épaisseur dépassant 10 micromètres. Une solution au problème consiste à remplir au moins partiellement les traversées d'un matériau métallique. Le remplissage aboutit à ce qui est couramment appelé un pilier. Grâce aux piliers, on réduit les déformations des couches conductrices supérieures.

Un procédé connu de fabrication des piliers consiste à faire un dépôt chimique (electroless) de nickel. La traversée est d'abord mise en contact avec une solution catalytique, généralement à base de palladium pour obtenir une surface métallique activée. Ensuite, on plonge la traversée dans un bain à base de diméthylaminoborane, couramment désigné sous la forme contractée DMAB, qui sert d'agent réducteur. Les polyimides notamment s'avèrent en effet inertes au DMAB. Ce procédé de dépôt chimique de nickel est utilisable sur toute surface métallique activée.

La description la plus connue du phénomène de dépôt chimique (electroless) est celle donnée par Van Meerakker dans un article de la revue "Journal of Applied Electrochemistry", 1981, Vol. 11, pages 395 et suivantes.

Le dépôt de métal procède par les réactions simultanées d'oxydation anodique de l'agent réducteur et de la réduction cathodique du métal. L'activation de la surface métallique de support qui constitue le fond d'une traversée doit à la fois permettre la déhydrogénation du réducteur et la désorption de l'hydrogène par recombinaison ou oxydation à une vitesse suffisante pour que le dépôt métallique se fasse. L'activation est faite en traitant la surface métallique avec une solution catalytique généralement faite à base de palladium. Par exemple, une activation faite selon un procédé humide consiste à mettre en contact la couche isolante et ses traversées avec une solution de chlorure de palladium (PdCl₂). Dans ce cas, l'activation n'a théoriquement lieu que sur la surface métallique du fond de chaque traversée. Dans le bain suivant de DMAB, le palladium présent au fond des traversées accumule le nickel. Normalement, la surface de la couche isolante est inerte à ce type de bain. Cependant, l'expérience montre qu'une nucléation de nickel apparaît sur la surface de la couche isolante ayant subi une activation. Cette nucléation crée des défauts d'isolation dans le réseau multicouche fini. Pour éviter ces défauts, il est nécessaire de protéger la surface extérieure de la couche isolante par un masque ne faisant apparaître que le fond des traversées.

Une autre forme de traitement catalytique est le procédé classique connu sous le nom de "lift-off". Ce procédé consiste à former un masque photorésistant sur la couche isolante de façon à ne faire apparaître que les traversées, puis à procéder à l'évaporation de palladium sous vide. Le palladium recouvre uniformément le fond des traversées et leurs parois latérales, ainsi que toute la surface du masque. Le masque est ensuite éliminé. Après le traitement catalytique, la carte est plongée dans un bain de DMAB pour le dépôt chimique de nickel. Ce dépôt se forme en présence du palladium à partir de toutes les parois de chaque traversée.

Les deux formes de traitement catalytique présentent des inconvénients. Dans la première forme décrite plus haut, il est nécessaire de recouvrir la couche isolante d'un masque photorésistant ne laissant apparaître que les traversées pour éviter les nucléations de nickel. Quant au procédé par lift-off, le masque s'impose normalement. Le procédé de masquage requiert plusieurs opérations exigeant un centrage précis sur les traversées. Le masquage est donc délicat, long et coûteux. De plus, il pose aussi un grave problème lorsque les traversées sont profondes, comme c'est généralement le cas des cartes d'interconnexion. Le masquage commence par l'étalement d'une résine photorésistante, par rotation de la carte par exemple. La couche de résine remplit les traversées et présente une surface relativement plane au-dessus de la couche isolante. Autrement dit, la couche de résine présente une épaisseur beaucoup plus importante à l'intérieur des traversées qu'à l'extérieur. Les conditions d'insolation d'une résine à photosensibilité positive, ou les conditions de développement d'une résine à photosensibilité négative dépendent de l'épaisseur de la résine. Il s'avère ainsi difficile d'obtenir un masque limité au seul contour des traversées et ne laissant aucune trace de résine sur les parois de la traversée. En outre, cette opération requiert un centrage précis sur chaque trou. En résumé, le masquage qui s'impose dans les procédés classiques consiste en des opérations supplémentaires longues, délicates et coûteuses, et donnent des résultats non satisfaisants.

Le procédé de "lift-off" présente un autre inconvénient. A cause de la présence de palladium sur toutes les parois d'une traversée, la croissance du nickel dans la traversée se développe verticalement et latéralement. Quand la traversée a un diamètre plus grand que sa profondeur, la couche de nickel croît en forme de U et présente une cuvette. De plus, les bords supérieurs de la couche de nickel s'élèvent et forment une couronne au-dessus de la surface de la couche isolante. La cuvette et la couronne s'opposent au nivellement désiré.

D'autre part, les procédés connus de fabrication de réseaux métalliques multicouches consistent à former itérativement les couches complètes désirées. Sur une couche métallique, on forme la couche isolante et on la grave pour y ménager des traversées. Puis, on remplit les traversées pour faire les piliers et on recouvre la couche isolante et ses piliers d'une autre couche métallique. On reprend ces étapes pour les couches supérieures. Afin d'accroître la densité d'interconnexion du réseau, il est souhaitable de superposer des piliers du réseau. Cela est possible si les piliers sont coplanaires avec la couche isolante qui les incorporent. Le procédé humide de dépôt chimique de nickel produit des piliers relativement coplanaires. Cependant, chaque pilier a un rebord dû à un effet de bord de la croissance du nickel au contact des parois latérales de la traversée. Ce rebord crée une légère cuvette sur la face supérieure du pilier. Le pilier supérieur superposé aura une cuvette plus creuse. Une trop grande dénivellation a l'inconvénient de créer des défauts dans la couche métallique. Par conséquent, il est en pratique impossible de superposer plus de deux ou trois piliers ainsi formés. La superposition requiert un centrage très précis dans toutes les opérations de masquage et de gravure pour aligner correctement deux piliers. De plus, ces opérations sont nécessaires dans les procédés connus. Le procédé de dépôt chimique par "lift-off" crée une grande cuvette dans des traversées larges et rend pratiquement impossible la formation d'un pilier supérieur. Il en est de même pour les traversées évasées. La solution actuelle consiste à décaler les traversées supérieures. Ce décalage est souvent fait en spirale autour d'une ligne verticale. Cependant, la section de cette spirale est beaucoup plus grande que celle des traversées et s'oppose à la haute densité désirée. En outre, une spirale disposant par exemple les traversés à 90° les unes des autres fait que la cinquième traversée se superposera à celle du bas et créera une dépression excessive. Il faut alors agrandir la section de la spirale, au détriment de la haute densité recherchée.

Il est aussi connu du document US-A-3672986 un procédé d'interconnexion dans un réseau métallique multicouche d'une carte électronique, consistant à déposer au moins des première et seconde couches métalliques superposées du réseau multicouche, à ménager une traversée ayant pour fond la première couche métallique et traversant la seconde couche métallique, et à former un pilier par dépôt chimique métallique dans la traversée pour relier les deux couches métalliques. Cependant, la formation du pilier nécessite l'emploi d'une base catalytique dans le matériau isolant du réseau multicouche.

L'invention présente un procédé n'ayant pas les inconvénients des procédés classiques de formation d'un réseau métallique multicouche par dépôt chimique.

L'invention a pour objet un procédé d'interconnexion dans un réseau métallique multicouche d'une carte électronique, tel que défini par les caractéristiques de la revendication 1.

Les caractéristiques et avantages de l'invention ressortent de la description qui suit, donnée à titre d'exemple et faite en référence aux dessins annexés.

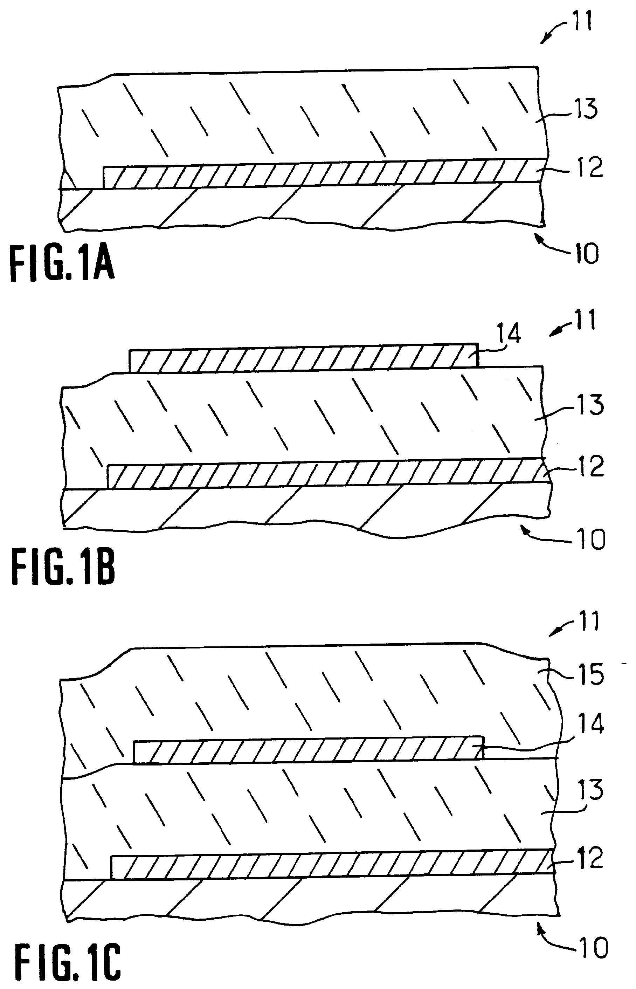

Dans les dessins, les figures 1A-1E sont des vues en coupe schématique partielle d'une carte présentant un réseau métallique multicouche pour la connexion d'au moins un circuit intégré, illustrant des phases successives d'un procédé d'interconnexion conforme à l'invention.

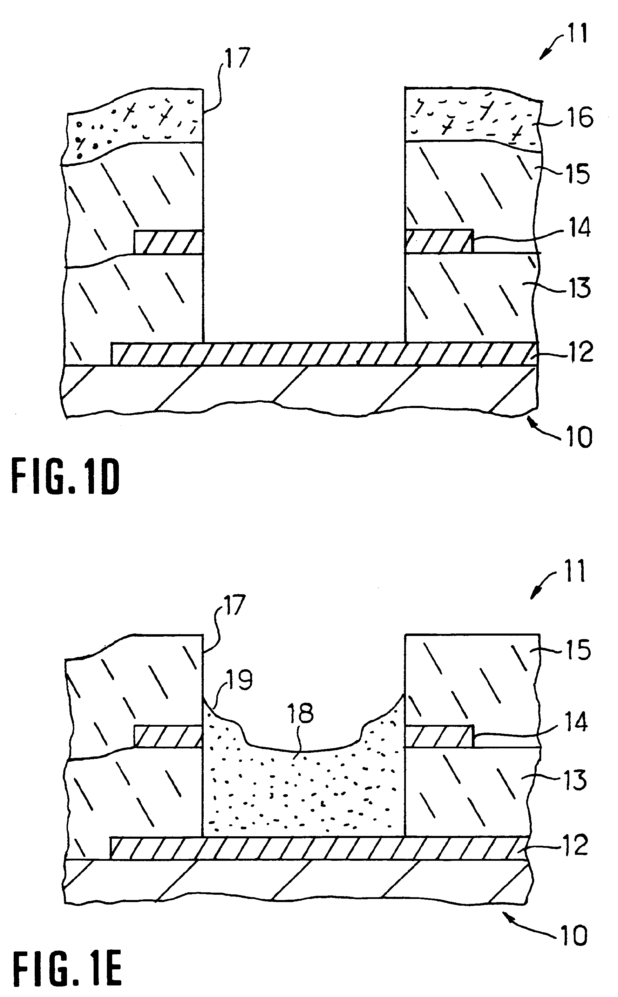

Les figures 1A-1E illustrent une carte 10 portant un réseau métallique multicouche 11 pour la connexion d'au moins un circuit intégré, non représenté. Le réseau 11 est vu en coupe schématique partielle au niveau d'un conducteur d'une couche conductrice métallique 12. Dans la figure 1A, la couche métallique 12 est recouverte uniformément d'une couche isolante 13. Au niveau de la figure 1A, il est prévu de former une traversée et un pilier réunissant le conducteur représenté de la couche métallique 12 à un conducteur d'une couche métallique supérieure. Selon l'invention, on forme les conducteurs de la couche métallique supérieure 14 sur la couche isolante 13, comme représenté sur la figure 1B. Les conducteurs des couches métalliques adjacentes sont ordinairement orthogonaux, comme illustré. Puis, comme illustré dans la figure 1C, on forme une couche isolante supérieure 15 uniformément sur toute la couche métallique supérieure 14. En pratique, le réseau 11 était fait de cuivre électrolytique déposé en couche de 5 µm d'épaisseur et de polyimide déposé en couche d'épaisseur de l'ordre de 10 µm. En référence à la figure 1D, un masque minéral 16 a été formé sur la couche isolante supérieure 15. Le masque 16 sert à graver successivement les couches sous-jacentes 15, 14 et 13 pour créer une traversée commune 17 ayant la couche métallique inférieure 12 comme paroi de fond. En pratique, les traversées dans le réseau 11 avaient un diamètre d'environ 40 µm et étaient espacées les unes des autres d'au moins 125 µm centre à centre. La gravure du polyimide a été faite par plasma et celle du cuivre par usinage ionique (ion milling). Le réseau 11 illustré dans la figure 1D a été activé avec une solution de chlorure de palladium. La carte 10 a ensuite été plongée dans un bain de DMAB selon le procédé humide de dépôt chimique de nickel. Il en est résulté le pilier 18 représenté sur la figure 1E. Le palladium déposé sur le cuivre dans la traversée 17 fait croître le nickel verticalement à partir de la couche 12, et à la fois verticalement et horizontalement à partir de la couche 14. On peut ainsi arrêter le dépôt au milieu de la traversée 17 illustrée pour avoir un contact efficace et fiable entre les couches métalliques 12 et 14. Un rebord 19 se forme au-dessus de la couche supérieure 14. Le rebord qui s'est formé en dessous s'est associé à la masse de nickel formée à partir de la couche 12.

Grâce à l'invention, la traversée commune 17 peut avoir une section sensiblement égale ou inférieure à sa profondeur et devient adaptée à tout dépôt chimique pour un remplissage sensiblement plan. Cependant, un remplissage partiel en forme de U peut créer un contact efficace et fiable entre les deux couches de cuivre.

L'invention n'est donc pas limitée à l'exemple décrit et illustré. D'une manière générale, elle peut s'appliquer à toute couche métallique conductrice utilisée dans une carte de connexion de circuits intégrés, le cuivre, l'or et l'aluminium notamment, ainsi qu'à tout procédé de dépôt chimique d'un métal de remplissage pour constituer un pilier et à l'interconnexion de plusieurs couches métalliques superposées. L'invention a aussi l'avantage d'éviter le problème du centrage des piliers et les masquages successifs pour le dépôt chimique, et de convenir à la haute densité de connexion recherchée. Bien entendu, tout mode de gravure connu peut être employé, par laser par exemple. De même, le masque pourrait être formé sur la couche métallique supérieure. Enfin, il est clair que la liaison conforme à l'invention peut aussi être faite entre deux couches métalliques non adjacentes.

## Revendications

1. Procédé d'interconnexion dans un réseau métallique multicouche (11) d'une carte électronique (10), consistant à déposer au moins des première et seconde couches métalliques superposées (12, 14) du réseau multicouche, à ménager une traversée (17) ayant pour fond la première couche métallique (12) et traversant la seconde couche métallique (14), et à former un pilier (18) par dépôt chimique métallique dans la traversée pour relier les deux couches métalliques, caractérisé en ce que le dépôt chimique consiste en la formation du pilier (18) par croissance à partir des deux couches métalliques (12, 14).

2. Procédé selon la revendication 1, caractérisée en ce que la traversée a un diamètre sensiblement égal ou inférieur à sa profondeur.

3. Procédé selon la revendication 1 ou 2, caractérisé en ce qu'il consiste à déposer chimiquement du nickel.

4. Procédé selon la revendication 3, caractérisé en ce qu'il consiste à plonger la carte (10) dans un bain de diméthylaminoborane selon le procédé humide de dépôt chimique de nickel.

5. Procédé selon l'une des revendications 1 à 4, caractérisé en ce que l'activation du réseau métallique multicouche (11) est faite avec une solution catalytique de chlorure de palladium.

6. Procédé selon l'une des revendications 1 à 5, caractérisé en ce que les couches métalliques sont séparées entre elles par des couches isolantes respectives faites en un matériau inerte au bain d'activation.

7. Procédé selon la revendication 6, caractérisé en ce que les couches isolantes sont faites en un matériau polymérisé, tel que le polyimide.

8. Procédé selon l'une des revendications 1 à 7, caractérisé en ce que les première et seconde couches métalliques ne sont pas adjacentes.

## Patentansprüche

1. Verbindungsverfahren in einem Mehrschichtmetallnetz (11) einer elektronischen Leiterkarte (10), das darin besteht, wenigstens eine erste und eine zweite übereinandergelagerte Metallschicht (12, 14) der Mehrschichtnetzes aufzubringen, ein Kontaktloch (17) vorzusehen, dessen Boden durch die erste Metallschicht (12) gebildet ist und das die zweite Metallschicht (14) durchsetzt, sowie durch chemische Metallabscheidung in dem Kontaktloch eine Säule (18) zur Verbindung der beiden Metallschichten zu bilden, dadurch gekennzeichnet, daß die chemische Abscheidung in der Bildung der Säule (18) durch Aufwachsen ausgehend von den zwei Metallschichten (12, 14) besteht.

2. Verfahren nach Anspruch 1, dadurch gekennzeichnet, daß das Kontaktloch einen Durchmesser aufweist, der im wesentlichen gleich seiner Tiefe oder kleiner ist.

3. Verfahren nach Anspruch 1 oder 2, dadurch gekennzeichnet, daß es darin besteht, Nickel chemisch abzuscheiden.

4. Verfahren nach Anspruch 3, dadurch gekennzeichnet, daß es darin besteht, die Karte (10) nach dem Naßverfahren zur chemischen Abscheidung von Nickel in ein Dimethylaminoboran-Bad zu tauchen.

5. Verfahren nach einem der Ansprüche 1 bis 4, dadurch gekennzeichnet, daß die Aktivierung des Mehrschichtmetallnetzes (11) mit einer katalytischen Lösung aus Palladiumchlorid durchgeführt wird.

6. Verfahren nach einem der Ansprüche 1 bis 5, dadurch gekennzeichnet, daß die Metallschichten jeweils untereinander durch Isolierschichten getrennt sind, die aus einem gegenüber dem Aktivierungsbad inerten Material hergestellt sind.

7. Verfahren nach Anspruch 6, dadurch gekennzeichnet, daß die Isolierschichten aus einem polymerisierten Material wie Polyimid hergestellt sind.

8. Verfahren nach einem der Ansprüche 1 bis 7, dadurch gekennzeichnet, daß die erste und die zweite Metallschicht nicht aneinandergrenzen.

## Claims

1. A method of interconnection in a multilayer metal network (11) of an electronic board (10) consisting of depositing at least first and second superimposed metal layers (12, 14) of the multilayer network, making a via hole (17) having the first metal layer (12) as its bottom and traversing the second metal layer (14), and forming a via (18) by chemical metal deposition in the via hole to connect the two metal layers, characterised in that the chemical deposition consists of the formation of the via (18) by growth from the two metal layers (12, 14).

2. A method according to claim 1, characterised in that the via hole has a diameter substantially equal to or less than its depth.

3. A method as claimed in claim 1 or 2, characterised in that it consists of chemically depositing nickel.

4. A method as claimed in claim 3, characterised in that it comprises plunging the board (10) into a bath of dimethylaminoborane according to the moist method of chemical deposition of nickel.

5. A method as claimed in one of claims 1 to 4, characterised in that the activation of the multilayer metal network (11) is performed with a catalytic solution of palladium chloride.

6. A method as claimed in one of claims 1 to 5, characterised in that the metal layers are separated from one another by respective insulating layers made of a material inert to the activation bath.

7. A method as claimed in claim 6, characterised in that the insulating layers are made of a polymerised material, such as polyimide.

8. A method as claimed in one of claims 1 to 7, characterised in that the first and second metal layers are not adjacent.
